# EUROPÄISCHE PATENTANMELDUNG

(11) **EP 2 242 102 A1**
(43) Veröffentlichungstag der Anmeldung: **20.10.2010**
(21) Anmeldenummer: 10001494.3
(22) Anmeldetag: 13.02.2010
(51) Int. Cl.: H01L 23/64, H01L 25/07, H01L 23/50, H02M 7/00

(54) **Vorrichtung zur Verringerung der Störabstrahlung in einem leistungselektronischen System**

(30) Priorität: 16.04.2009 DE 102009017621
(71) Anmelder: SEMIKRON Elektronik GmbH & Co. KG, 90431 Nürnberg (DE)
(72) Erfinder: Backhaus, Klaus, Dr., 90768 Fürth (DE); Frank, Thomas, 91207 Lauf (DE); Hager, Ludwig, 90491 Nürnberg (DE); Hopperdietzel, Renè, 90419 Nürnberg (DE); Knoth, Michael, 96450 Coburg (DE)

(57) **Zusammenfassung**

Vorrichtung zur Verringerung der Störabstrahlung in einem leistungselektronischen System mit einem Leistungshalbleitermodul oder mit einer Anordnung mindestens eines Leistungshalbleitermoduls, mit einem Grundpotential aufweisenden ersten Formkörper, mindestens zwei im Inneren der Vorrichtung angeordneten Gleichstromlastverbindungselementen unterschiedlicher Polarität zur Verbindung von Leistungshalbleiterbauelementen mit zugeordneten Anschlusselementen zur externen Verbindung der Vorrichtung. Hierbei weisen zwei Gleichstromlastverbindungselemente unterschiedlicher Polarität mindestens jeweils einen Abschnitt auf in dem diese flächig ausgebildet sind, wobei diese Abschnitte zueinander parallel und eng benachbart zueinander verlaufen und voneinander elektrisch isoliert sind. Weiterhin weist die Vorrichtung mindestens einen zweiten Formkörper mit einem flächig ausgebildeten ersten Teilformkörper auf, der im Bereich zwischen den beiden parallelen Abschnitten der Gleichstromlastverbindungselemente elektrisch isoliert von diesen angeordnet ist. Ebenso ist ein zweiter Teilformkörper mit dem ersten Formkörper elektrisch leitend verbunden.

## Beschreibung

Die Erfindung beschreibt eine Vorrichtung zur Verringerung der Störabstrahlung in einem leistungselektronischen System, welches entweder als einzelnes Leistungshalbleitermodul oder auch als eine Anordnung von mindestens einem Leistungshalbleitermodul mit weiteren Komponenten, wie Steuerelektronik oder passiven Bauelementen ausgebildet sein kann. Leistungshalbleitermodul in Druckkontaktausführung mit steuerbaren Leistungshalbleiterbauelementen. Einen Ausgangspunkt der Erfindung bilden Leistungshalbleitermodule wie sie beispielhaft aus der DE 10 2006 006 425 A1 bekannt sind.

Derartige Leistungshalbleitermodule bestehen nach dem Stand der Technik aus einem Gehäuse mit mindestens einem darin angeordneten elektrisch isolierenden Substrat angeordnet auf einer Wärmeabfuhreinrichtung. Das Substrat seinerseits weist eine elektrisch isolierte Anordnung von metallischen Verbindungsbahnen und hierauf befindlichen und mit diesen Verbindungsbahnen schaltungsgerecht verbundenen Leistungshalbleiterbauelementen auf. Weiterhin weisen die bekannten Leistungshalbleitermodule Anschlusselemente zur externen Verbindung von Last- und Hilfsanschlüssen sowie im Inneren angeordnete Verbindungselemente auf. Diese Verbindungselemente für schaltungsgerechte Verbindungen im Inneren des Leistungshalbleitermoduls sind zumindest zum Teil häufig als flächige Metallformkörper ausgebildet.

Weiterhin bekannt sind leistungselektronische Systeme, bei denen ein Standard-Leistungshalbleitermodul zusammen mit weiteren Komponenten zu einem komplexeren anwendungsspezifischen leistungselektronischen System kombiniert wird. Hierbei werden in einem gemeinsamen Gehäuse alle notwendigen Komponenten sowie zugehörige Verbindungselemente angeordnet und schaltungsgerecht verbunden. Zur externen Verbindung weisen derartigen leistungselektronische Systeme Anschlusselemente auf. Für den Anwender wirken derartige leistungselektronische Systeme wie die bekannten Leistungshalbleitermodule mit erweiterter Funktion.

Es ist ebenso bekannt die Gleichstromanschlusselemente mittels je eines Kondensators gegen Grundpotential zu verbinden. Derartige als "Y-Kondensatoren" bekannte Anordnungen dienen dazu Gleichtaktstörungen zu reduzieren. Durch die hohen Schaltfrequenzen der Leistungshalbleiterbauelemente entstehen sehr große Spannungsänderungen pro Zeiteinheit. Diese wiederum führen zur Abstrahlung elektromagnetischer Wellen, die die elektromagnetische Verträglichkeit (EMV) des leistungselektronischen Systems, also hier auch des einzelnen Leistungshalbleitermoduls, verschlechtern, wodurch diese gegebene Normwerte nicht einhalten.

Die Y-Kondensatoren reduzieren die Abstrahlung dieser elektromagnetischen Wellen, wozu sie allerdings möglichst nahe an der Quelle der Störung, dem Leistungshalbleiterbauelement, angeordnet werden sollten. Zudem sollte die zugehörige Verbindung möglichst geringe parasitäre Induktivitäten aufweisen um die Wirkung auch bei hohen Frequenzen nicht wesentlich zu verschlechtern

Gemäß dem Stand der Technik werden Y-Kondensatoren meist an den Gleichstromanschlusselementen der Leistungshalbleitermodule angeordnet, beanspruchen somit allerdings zusätzlichen Bauraum und verursachen durch die zusätzlichen Komponenten auch zusätzliche Kosten.

Der Erfindung liegt die Aufgabe zugrunde eine Vorrichtung zur Verringerung der Störabstrahlung eines leistungselektronischen Systems vorzustellen, wobei diese integraler, innerer Bestandteil des Systems sein sollte und auf zusätzliche Komponenten in Form von diskreten Y-Kondensatoren verzichtet werden kann.

Die Aufgabe wird erfindungsgemäß gelöst, durch die Maßnahmen gemäß Anspruch 1. Bevorzugte Ausführungsformen sind in den abhängigen Ansprüchen beschrieben.

Der erfinderische Gedanke geht von einem leistungselektronischen System aus, das als einzelnes Leistungshalbleitermodul oder als eine Anordnung mit einem Leistungshalbleitermodul vorliegt. Derartige Systeme weisen ein Gehäuse mit Anschlusselementen zur externen elektrischen Verbindung auf. In ihrem Inneren ist mindestens ein Leistungshalbleiterbauelement angeordnet, das mit den externen Anschlusselementen schaltungsgerecht verbunden ist. Hierbei sind einerseits Verbindungselemente für Hilfsanschlüsse sowie für Lastanschlüsse und hierbei speziell für mindestens zwei Gleichstromlastanschlüsse unterschiedlicher Polarität sowie für mindestens einen Wechselstromlastanschluss bekannt.

Erfindungsgemäß weisen zwei Gleichstromlastverbindungselemente unterschiedlicher Polarität mindestens jeweils einen Abschnitt auf, in dem diese flächig ausgebildet sind. Weiterhin verlaufen diese Abschnitte zueinander parallel und eng benachbart zueinander. Selbstverständlich sind die beiden Gleichstromlastanschlusselemente in ihrem Verlauf und auch in diesem speziellen Abschnitten voneinander elektrisch isoliert.

Die erfindungsgemäße Vorrichtung weist weiterhin einen Grundpotential aufweisenden ersten Formkörper aus elektrisch leitfähigem Material auf. Es kann bevorzugt sein, wenn dieser Formkörper eine Wärmeabfuhreinrichtung des Leistungshalbleitermoduls ist oder wenn dieser ein Teil des Gehäuses eines komplexen leistungselektronischen Systems ist.

Zur Ausbildung der Funktionalität eines Y-Kondensators innerhalb der Vorrichtung weist diese einen zweiten Formkörper aus elektrisch leitfähigem Material auf. Dieser zweite Formkörper wiederum weist einen ersten flächig ausgebildeten Teilformkörper auf, der im Bereich zwischen den beiden parallelen Abschnitten der Gleichstromlastverbindungselemente angeordnet und elektrisch isoliert von diesen ist. Ein zweiter Teilformkörper des zweiten Formkörpers ist mit dem ersten Formkörper der Vorrichtung elektrisch leitend verbunden ist.

Hierbei kann es besonders bevorzugt sein, wenn diese Verbindung derart ausgebildet ist, dass der gesamte zweite Formkörper in seiner Lage derart veränderbar ist, dass sein erster Teilformkörper den Bereich zwischen den beiden parallelen Abschnitten der Gleichstromlastverbindungselemente unterschiedlich stark füllt

Durch diese Ausbildung und Anordnung des zweiten Formkörpers erfüllt er nicht nur die grundsätzliche Funktion des Y-Kondensators, sondern es ist vielmehr möglich bei der Anordnung verschiedene Kapazitäten einzustellen und hierdurch die gesamte Vorrichtung besser auf die zukünftigen Anwendungsbedingungen einzustellen.

In einer weiteren bevorzugten Ausgestaltung ist der zweite Formkörper becherartig ausgebildet und umschließt hierdurch gemeinsam mit dem ersten Formkörper das mindestens eine Leistungshalbleiterbauelement, wie auch ein notwendiges Substrat fast vollständig. Hierbei weist der zweite Formkörper notwendige Aussparungen auf, um die notwendigen elektrischen Verbindungen zwischen Substrat bzw. Leistungshalbleiterbauelementen und den Anschlusselementen der Vorrichtung zu ermöglichen. Beispielhaft reicht hier einer der beiden Gleichstromlastverbindungselemente sowie verschiedenen Hilfsverbindungselemente durch den zweiten Formkörper hindurch und sind gegen diesen gegebenenfalls ausreichend elektrisch isoliert.

Weiterhin kann es bevorzugt sein in einem komplexen leistungselektronischen System, dass der Bereich zwischen den beiden parallelen Abschnitten der Gleichstromlastverbindungselemente direkt benachbart zu einer Seitenfläche eines Leistungshalbleitermodusl, das Teil des Systems, angeordnet ist. Hierbei ist das Leistungshalbleitermodul in thermisch leitender und elektrisch isolierender Verbindung auf dem ersten Formkörper angeordnet, während der zweite Formkörper mittels seines zweiten Teilformkörpers auf dem ersten Formkörper angeordnet ist. Hierbei kann es weiter bevorzugt sein, wenn der zweite Formkörper mindestens einen weiteren Teilformkörper aufweist, wodurch sich eine stapelförmige Anordnung mindestens bestehend aus dem weiterem Teilformkörper, dem ersten Gleichstromlastverbindungselement, dem zweitem Teilformkörper und dem zweitem Gleichstromlastverbindungselement ergibt.

Die erfinderische Lösung wird an Hand der Ausführungsbeispiele der Fig. 1 bis 5 weiter erläutert.

Fig. 1 zeigt das grundlegende Prinzip der Vorrichtung als Schaltskizze.

Fig. 2 zeigt eine Vorrichtung gemäß dem Stand der Technik.

Fig. 3 und 4 zeigen zwei Ausgestaltungen einer erfindungsgemäßen Vorrichtung in Schnittdarstellung.

Fig. 5 zeigt eine Ausgestaltung einer erfindungsgemäßen Vorrichtung in dreidimensionaler Ansicht.

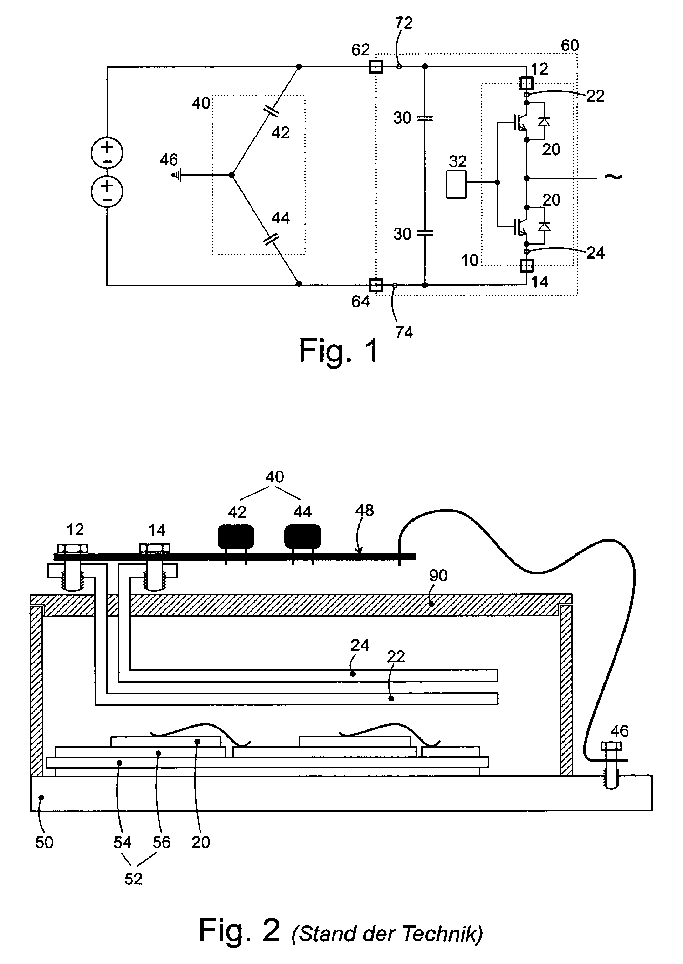

Fig. 1 zeigt das grundlegende Prinzip der Vorrichtung als Schaltskizze. Dargestellt ist hier ein Basiselement einer Vielzahl von leistungselektronischen Schaltungen eine Halbbrückenschaltung mit zwei Leistungshalbleiterbauelementen (20), hier jeweils ausgebildet als ein Transistor mit einer antiparallel geschalteten Diode. Derartige Halbbrückenschaltungen sind die schaltungstechnische Basis einer Vielzahl verschiedener Leistungshalbleitermodule (10). Weiterhin dargestellt sind die ersten Gleichstromlastverbindungselemente (22, 24) beider Polaritäten im Inneren des Leistungshalbleitermoduls (10), die hier mit jeweils zugeordneten ersten Anschlusselementen (12, 14) verbunden sind.

Ebenfalls dargestellt ist ein Zwischenkreiskondensator (30), der in leistungselektronischen Schaltungen der Zwischenspeicherung der Energie vor der Zuführung zu den Leistungshalbleiterbauelementen (20) dient. Dieser Zwischenkreiskondensator (30) ist ebenso wie eine Steuereinheit (32) und mindestens ein Leistungshalbleitermodul (10) häufig Teil eines komplexeren leistungselektronischen Systems (60). Diese weist ebenso wie das Leistungshalbleitermodul (10) als solches zweite Anschlusselemente (62, 64) zur externen Verbindung wie auch zweite Gleichstromlastanschlusselement (72, 74) beider Polaritäten auf.

Gemäß dem Stand der Technik ist hier ein Y-Kondensator (40), bestehend aus zwei diskreten Einzelkondensatoren (42, 44) mit den zweiten Anschlusselementen (72,74) des komplexen Systems (60) verbunden. Es ist ebenso bekannt diesen Y-Kondensator (40) mit den entsprechenden ersten Anschlusselementen (12, 14) des Leistungshalbleitermoduls (10) zu verbinden. Hierbei sind die beiden Einzelkondensatoren (42, 44) einerseits mit je einem zugeordneten Gleichstromlastverbindungselement (12, 14 oder 72, 74) und andererseits mit Grundpotential (76) verbunden.

Fig. 2 zeigt schematisch die Ausgestaltungen einer Vorrichtung mit einem Leistungshalbleitermodul (10) gemäß dem Stand der Technik in Schnittdarstellung. Dargestellt ist ein erster Formkörper (50), hier eine Wärmeabfuhreinrichtung beispielhaft in Ausgestaltung eines Kupfer- oder Aluminiumkörpers mit einem hierauf angeordneten und gegen die Wärmeabfuhreinrichtung elektrisch aber nicht thermischen isolierten Substrat (52). Die der Wärmeabfuhreinrichtung (50) abgewandte Oberfläche des Substrats (52) weist auf einem Isolierkörper (54) eine Mehrzahl von Leiterbahn (56) mit unterschiedlichen elektrischen Potentialen auf. Auf einigen dieser Leiterbahnen (56) sind Leistungshalbleiterbauelemente (20) angeordnet und schaltungsgerecht, beispielhaft mittels Drahtbondverbindungen, verbunden.

Ein Gehäuse (90) umschließt das Substrat (52) und weist weitere Verbindungselemente auf, hier dargestellt sind zwei erste Gleichstromlastverbindungselemente (22, 24) unterschiedlichen Potentials. Diese ersten Gleichstromlastverbindungselemente (22, 24) verbinden, wie aus dem Stand der Technik bekannt, die zugeordneten Leiterbahnen (56) des Substrats (52) mit Anschlusselementen (12, 14) zur externen Verbindung der Vorrichtung. Auf die Darstellung eines Wechselstromlastverbindungselementes wird hier wie auch in den beiden folgenden Figuren der Übersichtlichkeit halber verzichtet.

Der Y-Kondensator (40) ist hier auf einer Zusatzplatine (48) oberhalb des Leistungshalbleitermoduls (10) anordnet. Gemäß der schaltungstechnischen Ausgestaltung gemäß Fig. 1 sind die beiden Kondensatoren (42, 44) des Y-Kondensators (40) mit einem jeweils zugeordneten ersten Gleichstromanschlusselemente (22, 24) und mit Grundpotential (46) hier dasjenige Potential des ersten Formkörpers (50) verbunden.

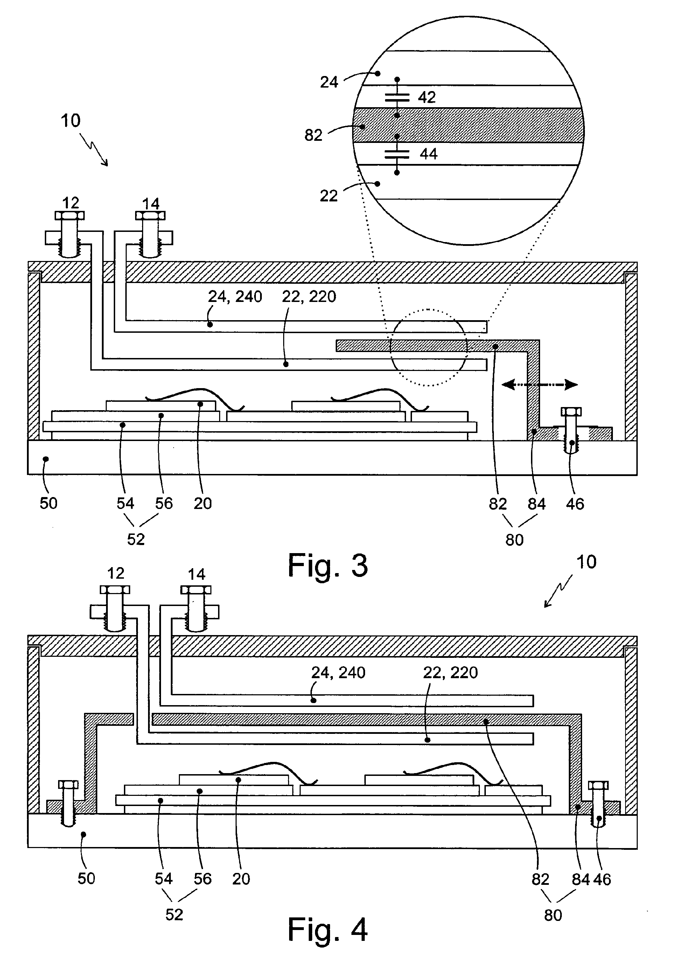

Fig. 3 und 4 zeigen schematisch zwei Ausgestaltungen einer erfindungsgemäßen Vorrichtung mit jeweils einem Leistungshalbleitermodul (10) in Schnittdarstellung, ausgehend von einer Vorrichtung gemäß Fig. 2.

Die Ausgestaltung gemäß Fig. 3 weist im Bereich oberhalb des Substrates (52) verlaufend die ersten Gleichstromlastverbindungselemente (22, 24) in jeweils einem Abschnitt (220, 240) parallel zueinander auf, wobei diese Abschnitte (220, 240) zumindest teilweise flächig, mit zueinander parallelen Flächennormalen, ausgestaltet sind. Im Bereich der flächigen Ausgestaltung (220, 240) der ersten Gleichstromlastverbindungselemente (22, 24) ist ein zweiter Formkörper (80), hier ausgestaltet als ein Z-förmiges Stanz- Biegeteil, derart angeordnet, dass ein erster Teilformkörper (82) flächig zwischen den beiden Abschnitten (220, 240) der ersten Gleichstromlastverbindungselemente (22, 24) zu liegen kommt. Selbstverständlich sind die ersten Gleichstromlastverbindungselemente (22, 24) gegeneinander wie auch gegen den zweiten Formkörper (80) elektrisch isoliert. Durch diese Ausgestaltung wirkt der Z-förmige zweite Formkörper (80) wie ein Y-Kondensator (40) mit je einem Kondensator (42, 44) zwischen einem erste Gleichstromlastverbindungselement (22, 24) und dem auf Grundpotential liegenden ersten Formkörper (50).

Der zweite Formkörper (80) weist weiterhin einen zweiten Teilformkörper (84) auf der elektrisch leitend mit dem ersten Formkörper (50), der Wärmeabfuhreinrichtung, verbunden ist. Diese Verbindung ist derart ausgebildet, dass der gesamte zweite Formkörper (80) parallel zum Substrat (52) und damit zu den parallelen flächigen Abschnitten (220, 240) der ersten Gleichstromlastverbindungselemente (22, 24) verschiebbar ist. Dies wird im einfachsten Fall durch eine langlochförmige Ausnehmung im zweiten Teilformkörper (84) erreicht. Durch diese Ausgestaltung kann die Kapazität der beiden hierbei entstandenen Kondensatoren (42, 44) eingestellt und an die jeweilige Anwendung angepasst werden.

Die Ausgestaltung gemäß Fig. 4 weist bei im Übrigen gleichen Merkmalen keinen in seiner Lage veränderbaren zweiten Formkörper auf. Demgegenüber ist hier der zweite Formkörper (80) becherförmig ausgebildet und umschließt mit der Wärmeabfuhreinrichtung, dem ersten Formkörper (50) das Substrat (52) allseitig. Zur Durchführung mindestens eines ersten Gleichstromlastverbindungselements (22) und von Hilfsverbindungselementen weist der becherförmige zweite Formkörper (80) an geeigneten Stelle Ausnehmungen auf. Selbstverständlich sind diese Verbindungselemente (22, 24) gegenüber dem zweiten Formkörper (80) elektrisch isoliert ausgebildet.

Vorteilhaft neben der bereits genannten Funktion des zweiten Formkörpers (80), der Unterdrückung von Störabstrahlung eignet sich die Ausgestaltung gemäß Fig. 4 besonders zur Abschirmung des Substrats vor hochfrequenten Feldern.

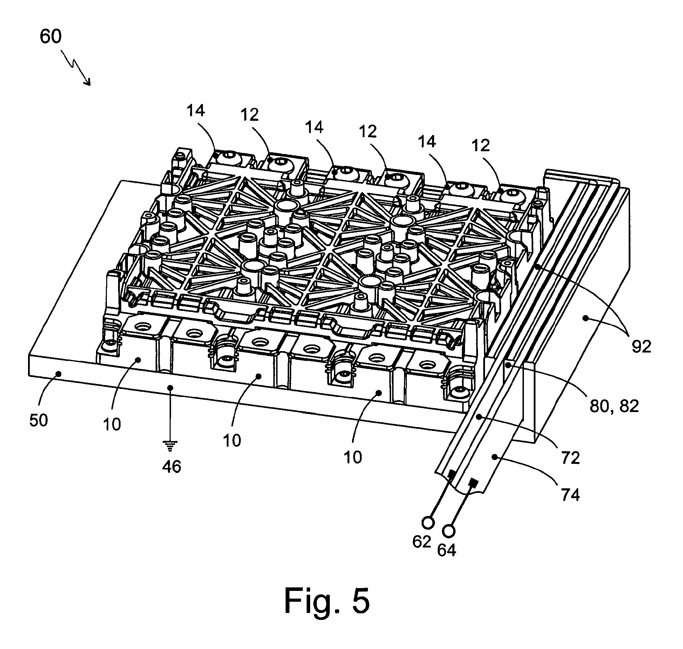

Fig. 5 zeigt eine Ausgestaltung einer erfindungsgemäßen Vorrichtung in dreidimensionaler Ansicht, wobei diese Vorrichtung aus einem ersten Formkörper (50) einer Mehrzahl von Leistungshalbleitermodulen (10), einer Kondensatoreinheit und einer Steuereinheit in einem gemeinsamen Gehäuse besteht. Dargestellt sind hier nur die wesentlichen Komponenten wie erster Formkörper (50), Leistungshalbleitermodule (10) und zweite Gleichstromlastverbindungselemente (72, 74) mit angedeuteten zweiten Anschlusselementen (62, 46). Die Leistungsmodule (10) sind hierbei in thermischen leitender und elektrisch isolierender Verbindung mit dem ersten Formkörper (50).

Von den Leistungshalbleitermodulen (10) reichen im Inneren des Gehäuses diese zweiten Gleichstromlastverbindungselemente (72, 74) zu den zweiten Anschlusselementen (62, 64), die der externen Kontaktierung dienen. Diese zweiten Gleichstromlastverbindungselemente (72, 74) sind in ihrem gesamten Verlauf soweit möglich eng benachbart angeordnet um parasitäre Induktivitäten klein zu halten.

Erfindungsgemäß weisen diese zweiten Gleichstromlastverbindungselemente (72, 74) hier im Bereich neben den Leistungshalbleitermodulen (10) einen Abschnitt auf in dem sie flächig ausgebildet sind und die Flächennormalen dieser Flächen parallel zueinander liegen. Hierdurch entstehen durch diese Flächen gleichsam Platten, die im Weiteren jeweils einem Plattenkondensator zugeordnet sind. Durch die Anordnung eines zweiten Formkörpers (80) der einen ebenfalls flächigen Teilformkörper (82) aufweist zwischen den beiden flächigen Abschnitten der zweiten Gleichstromlastanschlusselemente (72, 74) bildet dieser die jeweils zweite Platte eines Plattenkondensators. Durch die elektrisch leitende, hier einstückig ausgebildete, Verbindung dieses zweiten Formkörpers (80) mit dem ersten auf Grundpotential (46) liegenden ersten Formkörper (50) wird der Y-Kondensator (40) gemäß Schaltung nach Fig. 1 ausgebildet.

Es kann, wie hier dargestellt, ebenfalls bevorzugt sein jeweils benachbart zu den zweiten Gleichstromlastverbindungselementen (72, 74) auf ihrer Außenseite weiterer Formkörper (92) vorzusehen, die ebenfalls elektrisch von den zweiten Gleichstromlastverbindungselemente (72, 74) isoliert und mit dem ersten Formkörper (50) elektrisch leitende verbunden vorgesehen sind. Diese dienen der weiteren Verbesserung der Abschirmung vor hochfrequenten Feldern.

## Patentansprüche

1. Vorrichtung zur Verringerung der Störabstrahlung in einem leistungselektronischen System mit einem Leistungshalbleitermodul (10) oder mit einer Anordnung (60) mindestens eines Leistungshalbleitermoduls (10), mit mindestens einem Leistungshalbleiterbauelement (20), mit einem Grundpotential (46) aufweisenden ersten Formkörper (50) aus elektrisch leitfähigem Material, mindestens zwei im Inneren der Vorrichtung angeordneten ersten oder zweiten Gleichstromlastverbindungselementen (22, 24, 72, 74) unterschiedlicher Polarität zur schaltungsgerechten Verbindung das Leistungshalbleiterbauelemente (20) mit zugeordneten ersten oder zweiten Anschlusselementen (12, 14, 62, 64) zur externen elektrischen Verbindung der Vorrichtung,
wobei zwei erste oder zweite Gleichstromlastverbindungselemente (22, 24 72, 74) unterschiedlicher Polarität mindestens jeweils einen Abschnitt (220, 240) aufweisen in dem diese flächig ausgebildet sind, diese Abschnitte (220, 240) zueinander parallel und eng benachbart zueinander verlaufen und voneinander elektrisch isoliert sind,
wobei die Vorrichtung mindestens einen zweiten Formkörper (80) aus elektrisch leitfähigem Material aufweist, der einen ersten flächig ausgebildeten Teilformkörper (82) aufweist der im Bereich zwischen den beiden parallelen Abschnitten (220, 240) der ersten oder zweiten Gleichstromlastverbindungselemente (22, 24, 72, 74) elektrisch isoliert von diesen angeordnet ist und der einen zweiten Teilformkörper (84) aufweist, der mit dem ersten Formkörper (50) elektrisch leitend verbunden ist.

2. Vorrichtung nach Anspruch 1,
wobei der zweite Formkörper (80) gegenüber den ersten oder zweiten Gleichstromanschlusselementen (22, 24, 72, 74) derart in seiner Position hierzu veränderbar angeordnet ist, dass sein erster Teilformkörper (82) den Bereich zwischen den beiden parallelen Abschnitten (220, 240) der ersten oder zweiten Gleichstromlastverbindungselemente (22, 24, 72, 74) unterschiedlich stark füllt.

3. Vorrichtung nach Anspruch 1,
wobei der erste Formkörper (50) eine Wärmeabfuhreinrichtung des Leistungshalbleitermoduls (10) ausbildet und der zweite Formkörper (80) vollständig im Inneren eines Gehäuses (90) des Leistungshalbleitermoduls (10) angeordnet ist.

4. Vorrichtung nach Anspruch 3,
wobei der zweite Formkörper (80) becherartig mit notwendigen Aussparungen ausgebildet ist und gemeinsam mit dem ersten Formkörper (50) das Substrat (52) fast vollständig umschließt.

5. Vorrichtung nach Anspruch 1,
wobei der Bereich zwischen den beiden parallelen Abschnitten der zweiten Gleichstromlastverbindungselemente (72, 74) bei der Anordnung mit mindestens einem Leistungshalbleitermodul (10) direkt benachbart zu einer Seitenfläche des Leistungshalbleitermodul (10) angeordnet ist, das Leistungshalbleitermodul (10) in thermischen leitender und elektrisch isolierender Verbindung auf dem ersten Formkörper (50) angeordnet ist und der zweite Formkörper (80) mittels seines zweiten Teilformkörpers (84) ebenfalls auf dem ersten Formkörper (50) angeordnet ist.
